(19) Europäisches Patentamt / European Patent Office / Office européen des brevets

(11) **EP 2 566 808 B1**

(12) **EUROPÄISCHE PATENTSCHRIFT**

(45) Veröffentlichungstag und Bekanntmachung des Hinweises auf die Patenterteilung:
**28.06.2017** **Patentblatt 2017/26**

(21) Anmeldenummer: **11715908.7**

(22) Anmeldetag: **14.04.2011**

(51) Int Cl.:
**B81C 1/00** (2006.01)

(86) Internationale Anmeldenummer:
**PCT/EP2011/055946**

(87) Internationale Veröffentlichungsnummer:
**WO 2011/138148 (10.11.2011 Gazette 2011/45)**

(54) **VERFAHREN ZUR HERSTELLUNG EINES GEGENLAGERS MIT ASPHÄRISCHEM MEMBRANBETT**

METHOD FOR THE PRODUCTION OF A COUNTERBEARING WITH ASPHERICAL MEMBRANE BED

PROCÉDÉ DE PRODUCTION D'UNE BUTÉE DOTÉE D'UN SUPPORT DE MEMBRANE ASPHÉRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.05.2010 DE 102010028773**

(43) Veröffentlichungstag der Anmeldung:
**13.03.2013 Patentblatt 2013/11**

(73) Patentinhaber: **Endress+Hauser GmbH+Co. KG**
**79689 Maulburg (DE)**

(72) Erfinder:
• **THAM, Anh, Tuan**
**10243 Berlin (DE)**
• **STOLZE, Dieter**
**14469 Potsdam (DE)**
• **TEIPEN, Rafael**
**10407 Berlin (DE)**

(74) Vertreter: **Andres, Angelika Maria**
**Endress+Hauser (Deutschland) AG+Co. KG**
**PatServe**
**Colmarer Strasse 6**
**79576 Weil am Rhein (DE)**

(56) Entgegenhaltungen:
**US-A1- 2004 256 585 US-B2- 7 360 431**

EP 2 566 808 B1

**Beschreibung**

Die vorliegende Erfindung betrifft ein Gegenlager mit einem aspärischen Membranbett für einen Drucksensor, einen Drucksensor mit einem solchen Gegenlager, insbesondere einen Differenzdrucksensor mit einem oder zwei solcher Gegenlager, sowie ein Herstellungsverfahren dafür.

Drucksensoren umfassen gewöhnlich ein Gegenlager, eine Messmembran und einen Wandler, wobei die Messmembran an dem Gegenlager befestigt ist, wobei die Messmembran mit mindestens einem Druck beaufschlagbar ist und eine druckabhängige elastische Verformung aufweist, und wobei der Wandler ein von der Verformung der Messmembran abhängiges Signal bereitstellt. Insbesondere bei Differenzdrucksensoren weist das Gegenlager weiterhin ein Membranbett auf, an welchem die Messmembran im Falle einer Überlast anliegt, um die Messmembran gegen eine weitere Auslenkung abzustützen. Hierbei ist es vorteilhaft, wenn das Membranbett eine Kontur aufweist, welche der Biegelinie der Messmembran entspricht, weil dadurch offensichtlich eine optimale Abstützung der Messmembranüberlastfall gegeben ist. Ein Membranbett mit einer solchen Kontur ist beispielsweise in der Patentschrift US 7,360,431 B2 offenbart, wobei der Abstand von der Membranebene D(r) gegeben ist, durch die Gleichung:

$$D(r) = D_{max} \left(1 - \left(r / R\right)^2\right)^2$$

wobei r der radiale Abstand des betrachteten Punkts des Membranbetts von der Mittelachse von der Membran ist, wobei $D_{max}$ die maximale Tiefe des Membranbetts ist, und wobei R der Radius der Membran ist.

Die genannte Patentschrift offenbart unter anderem, ein solches Membranbett durch ein lithographisches Verfahren herzustellen, bei welchem eine lichtempfindliche Schutzschicht auf die Oberfläche eines Siliziumsubstrats oder eines Glassubstrats aufgetragen wird, wobei die Schutzschicht anschließend durch eine der Membranbettkontur entsprechende Grauskalenverteilung zu belichten ist, um eine konkave Oberfläche in der Schutzschicht abzubilden. Anschließend wird das Silizium- oder Glassubstrat mit der solchermaßen präparierten Schutzschicht einen Ätzverfahren oder ähnlichem ausgesetzt, um die Abbildung tatsächlich in die gewünschte Oberflächenstruktur im Substratmaterial umzusetzen.

Das beschriebene Herstellungsverfahren ist jedoch insoweit schwierig zu beherrschen, als eine gleichmäßige Präparation der konkaven Strukturen durch Belichten von Grauskalenmasken über einen gesamten Wafer mit hinreichend geringen Toleranzen schwierig ist. Zudem lassen sich mit dem Verfahren die gewünschten Konturen allenfalls mit einer Tiefe von etwa 2 Mikrometern mit einer akzeptablen Genauigkeit präparieren. Weiterhin ist das beschriebene Verfahren zeitaufwendig und teuer.

Darüber hinaus beschreibt das Patentdokument US 2004/256585 A1 ein Ventil mit einem Membranbett, das durch Laserablation hergestellt wird.

Es ist daher die Aufgabe der vorliegenden Erfindung, die genannten Nachteile des Standes der Technik zu überwinden.

Die Aufgabe wird erfindungsgemäß gelöst durch das Verfahren gemäß dem unabhängigen Patentanspruch 1.

Das erfindungsgemäße Verfahren zum Herstellen eines Gegenlagers mit einem Membranbett umfasst Bereitstellen eines Gegenlagerkörpers, welcher beispielsweise ein Halbleitermaterial, insbesondere Silizium aufweist, und Abtragen des Materials mittels eines Laserablationsverfahren von einer Oberfläche des Gegenlagerkörpers.

Das Verfahren umfasst weiterhin die folgenden Schritte: Oxidation der Siliziumoberfläche nach erfolgter Laserablation und Ätzen der bearbeiteten und oxidierten Oberfläche.

In einer derzeit bevorzugten Ausgestaltung der Erfindung betrifft das Verfahren die Herstellung von Gegenlagern in einkristallinen Gegenlagerkörpern, welche insbesondere Silizium aufweisen.

Das Abtragen mittels Laserablation kann gemäß einer Weiterbildung der Erfindung insbesondere schichtweise erfolgen.

Dieses Verfahren hat die Vorteile, dass z.B. keine Prägeformen kostenaufwändig hergestellt werden müssen, oder z.B. beim Schleifen mit Diamantwerkzeug hochwertiges Material verschlissen und damit verbraucht wird.

Für eine optimale Oberflächenbeschaffenheit ist es derzeit bevorzugt, zur Laserablation Pulsdauern im Bereich oder unterhalb des Bereichs der Wechselwirkungszeit des Elektronengases mit dem Kristallgitter, welche im Pikosekunden-Bereich liegt, zu verwenden. Die Pulsdauern liegen daher beispielsweise im Pikosekunden- und Femtosekunden-Bereich. Dadurch ist gewährleistet, dass während der Lasereinstrahlung das Material nicht weiter schmilzt und eine erhöhte Rauhigkeit entsteht, sondern dass die Energie des Laserpulses zunächst nur vom Elektronengas absorbiert wird. Anschließend, wenn die Einstrahlung eines Laserpulses bereits beendet ist, wird die Energie des Elektronengases an das Gitter übertragen, so dass das Material schlagartig verdampft, ohne dass weiteres Material schmilzt. Bei Intensitäten von mehr als $10^{10}$ W/cm$^2$ werden Materialien wie Si und Metalle verdampft. Aufgrund der kurzen Zeiten werden die Schmelzzone und damit die damit einhergehende Rauhigkeit deutlich verringert.

In einer Weiterbildung der Erfindung erfolgt die Laserablation mittels ultrakurzer Laserpulse, insbesondere mit Laserpulsen im Zeitbereich von 100 Femtosekunden bis zu einigen 10 Pikosekunden.

Die Dauer eines Laserpulses beträgt beispielsweise nicht mehr als 30 Pikosekunden, vorzugsweise nicht mehr als 20 Pikosekunden, weiter bevorzugt nicht mehr als 15 Pikosekunden, und besonders bevorzugt nicht mehr als 10 Pikosekunden.

Die Dauer eines Laserpulses beträgt beispielsweise nicht weniger als 100 Femtosekunden, insbesondere nicht weniger als 200 Femtosekunden

In einer Weiterbildung der Erfindung beträgt die Leistung eines Laserpulses mehr als $10^{10}$ Watt/cm$^2$.

Gemäß einer Ausgestaltung der Erfindung kann der Laser beispielsweise ein diodengepumpter Nd:YVO$_4$ MOPA-Laser sein.

Weitere Einzelheiten zur Laserablation sind beispielsweise der Abhandlung von A. Gillner, A. et al. "High quality laser machining for tool and part manufacturing using innovative machining systems and laser beam sources" Proc. of the 3rd CIRP Int. Conf. High Performance Cutting (HPC), Dublin, Ireland, June 12-13, 2008 zu entnehmen.

In einer Weiterbildung der Erfindung wird das Ätzen, welches nach der Laserablation erfolgt, in Form von HF-Ätzen durchgeführt.

In einer Weiterbildung der Erfindung wird durch das Abtragen mittels Laserablation eine Kontur präpariert, welche rotationssymmetrisch um eine Achse senkrecht zur Oberfläche des Siliziumkörpers verläuft ist.

Das Gegenlager weist einen Gegenlagerkörper mit einem Membranbett zum Abstützen einer Messmembran auf, wobei das Membranbett eine Kontur aufweist, die im wesentlichen der Biegelinie der Messmembran bei der Berührung des Zentrums des Membranbetts durch die Messmembran entspricht, wobei die Kontur durch das erfindungsgemäße Verfahren erhältlich ist.

In einer Weiterbildung der Erfindung weist die Kontur des Membranbetts eine maximale Tiefe $D_{max}$ auf mit einem Wert von nicht weniger als 4 $\mu$m, insbesondere nicht weniger als 8 $\mu$m, weiter bevorzugt nicht weniger als 12 $\mu$m und besonders bevorzugt nicht weniger als 16 $\mu$m.

In weiteren Ausgestaltungen der Erfindung werden Werte für $D_{max}$ von nicht weniger als 20 $\mu$m, insbesondere nicht weniger als 25 $\mu$m erreicht.

Beispielsweise haben Polster et al. auf dem 19-ten MicroMechanics Europe Workshop Im September 2008 AlN-Membranen vorgestellt, welche bei einem Durchmesser von etwa 1,5 mm und einer Stärke von etwa 0,3 $\mu$m eine druckabhängige Auslenkung von 25 $\mu$m bis über 30 $\mu$m aufwiesen. Auch für diese Membranen ist ein erfindungsgemäßes Gegenlager geeignet.

Die Kontur des Membranbetts kann beispielsweise beschrieben werden durch die Gleichung:

$$D(r) = D_{max} \left(1 - (r / R)^2\right)^2$$

wobei r der radiale Abstand des betrachten Punkts von der Achse der rotationssymmetrischen Kontur ist, und D(r) die Tiefe gegenüber einer durch den Rand der Kontur bei r = R definierten Ebene beschreibt.

Die auslenkbaren Durchmesser der Messmembranen welche im wesentlichen 2*R betragen, weisen einen Wert von beispielsweise nicht weniger als 0,5 mm insbesondere nicht weniger als 1 mm auf.

Insbesondere Messmembranen für kleine Druckbereiche in der Größenordnung von nicht mehr als 40 mbar, insbesondere nicht mehr als 20 mbar können dabei aber auch größere Durchmesser aufweisen, beispielsweise Durchmesser zwischen 6 mm und 2 mm.

Der Gegenlagerkörper kann insbesondere aus Metall, Glas, Keramik oder einem Halbleitermaterial bestehen, wobei Halbleitermaterialien, insbesondere Si, derzeit bevorzugt sind.

Der Drucksensor umfasst eine Messmembran die über dem erfindungsgemäßen Membranbett positioniert und mit dem Gegenlagerkörper fest verbunden ist.

Ein Differenzdrucksensor umfasst eine Messmembran die zwischen zwei Membranbetten positioniert und mit den beiden Gegenlagerkörpern fest verbunden ist.

Der Drucksensor wird insbesondere im so genannten Full-Wafer-Bonding hergestellt, wobei ein Messmembranwafer mit einem Gegenkörperwafer oder zwei Gegenkörperwafern gefügt wird, bevor die Sensoren vereinzelt werden.

Die Erfindung wird nun anhand der in den Zeichnungen dargestellten Ausführungsbeispiele erläutert. Es zeigt:

Fig. 1:     einen schematischen Längsschnitt durch ein Beispiel eines Differenzdrucksensors;

Fig. 2a:    einen Längsschnitt durch eine axialsymmetrische, asphärische Kontur, welche für das Membranbett des Gegenlager aus zu präparieren ist;

Fig. 2b:    einen Längsschnitt durch die Kontur aus Fig. 2a, welche zur Präparation in kreisförmigen Schichten zerlegt ist, die aus dem Material des Gegenlagerkörpers abzutragen sind, wobei die resultierenden Stufen an den Übergängen der Schichten erkennbar sind;

Fig. 3:     eine schematische Darstellung der resultierenden Rauhigkeiten jeweils nach den Verfahrensschritten Laserablation, Oxidation und Ätzen; und

Fig. 4:     Weißlichtinterferometerdaten des Zentrums eines Membranbetts nach der Laserablation.

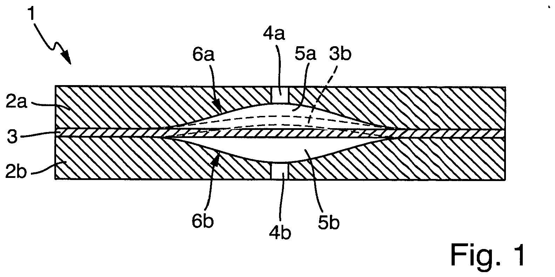

Der in Fig. 1 dargestellte Differenzdrucksensor umfasst eine flexible Messmembran 3 und zwei Gegenlager 2a und 2b. In Oberflächen der Gegenlager 2a und 2b sind asphärisch geformten Kavitäten 5a und 5b präpariert, so dass die solchermaßen präparierten Oberflächen der Gegenlager als Membranbetten 6a, 6b zum Abstützen der Messmembran 3 im Falle einer einseitigen Überlast dienen. Durch die Gegenlager erstrecken sich Bohrungen 4a und 4b, über welche die zu bestimmenden Drücke auf die Messmembran übertragen werden. Hierbei kann es sich um die Drücke des Messmediums direkt oder die Drücke eines Druckübertragungsmediums handeln. Mit den gestrichelten Linien ist die ausgelenkte Membran für den Fall dargestellt, dass der Druck in Kavität 5b größer ist als in Kavität 5a.

Im derzeit bevorzugten Verfahren erfolgt die Präparation des asphärischen Membranbetts in Silizium in drei Schritten.

Zunächst wird die Form des Membranbetts mittels Laserablation, also Abtragen bzw. Verdampfen mittels Laserlicht, mit ultrakurzen Laserpulsen präpariert. Dadurch ist es möglich, über vorgegebene geometrische Flächen, in diesem Fall kreisförmige Flächen, Si-Material schichtweise mit Schichtdicken von wenigen 100 nm zu verdampfen, ohne das Material aufzuschmelzen.

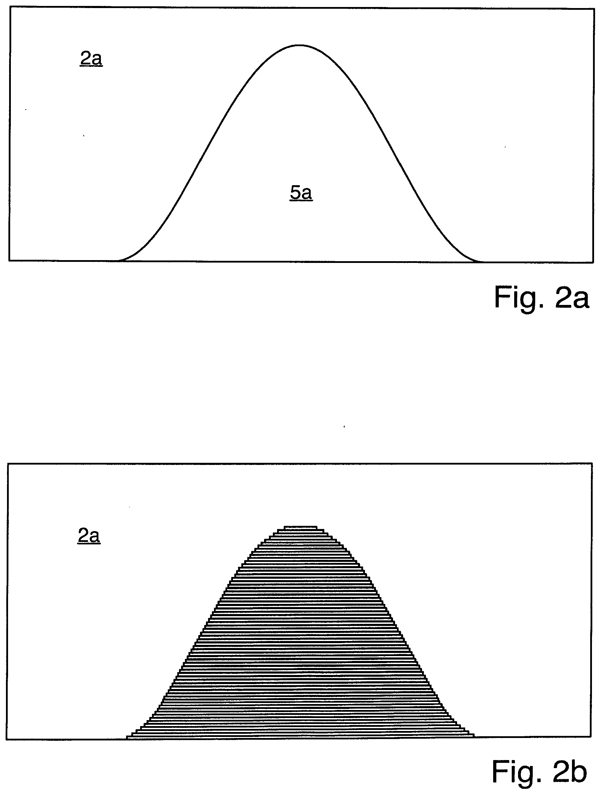

Der Radius der kreisförmigen Schichten wird so variiert, dass näherungsweise die angestrebte asphärische Form typischerweise mit einer maximalen Tiefe $d_{max}$ von einigen $\mu$m hergestellt wird, wie in Fig. 2b dargestellt ist, um die in Fig. 2a gezeigte Kontur zu approximieren.

Durch das Entfernen des Siliziums mittels Laserablation im schichtweisen Abtrag werden Stufen an den Übergängen von einer Schicht zur nächsten gebildet. Der Prozess des Laserabtrags bedingt zudem Rauhigkeiten in der Größenordnung unterhalb von 1 $\mu$m, wobei die Rauhigkeit mit jeder zusätzlichen Schicht, d.h. mit zunehmender Tiefe des Membranbetts tendenziell kumulativ zunimmt. Die Stufen an den Übergängen von einer Schichttiefe zur nächsten und resultierende Spitzen aufgrund der Rauhigkeit des Laserabtrags führen dazu, dass die Membran im Überlastfall am Membranbett lokal höheren mechanischen Spannungen ausgesetzt wäre, wenn das Membranbett in diesem Zustand belassen würde. Dies könnte unter Umständen die Überlastfestigkeit der abgestützten Messmembranen beeinträchtigen.

Daher wird das Material in einer derzeit bevorzugten Ausgestaltung der Erfindung nach der Laserablation, mittels einer chemischen Behandlung geglättet.

Zu diesem Zweck wird das Si-Material zunächst oxidiert, so dass vornehmlich die vorstehenden Spitzen und Kanten des Membranbetts in $SiO_2$ umgewandelt werden.

In einem weiteren Schritt wird die Oberfläche mittels eines etablierten Ätzverfahrens, dem HF-Ätzen bearbeitet, so dass das zuvor entstandene $SiO_2$ entfernt und die Rauhigkeit der Oberfläche signifikant reduziert wird.

Mit der Oxidation und der anschließenden Ätzung des Oxids wird also mit gesicherten Methoden der Halbleiterprozesstechnik das durch Laserablation vorbereitete, asphärische Membranbett mit einer hinreichend glatten Oberfläche präpariert, das die Abstützung der Membran gewährleistet und die lokalen mechanischen Spannungen im Überlastfall minimiert.

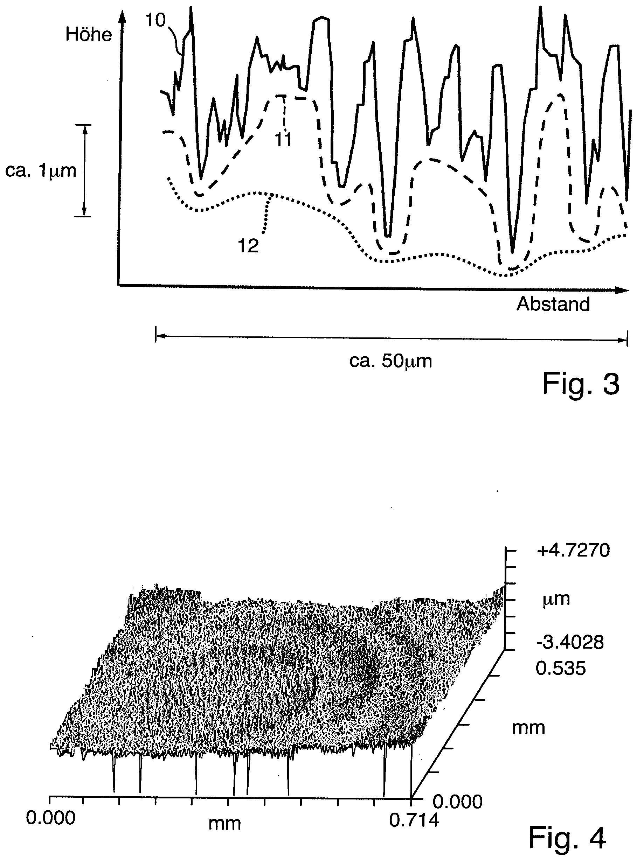

Der in Fig. 3 dargestellte, schematische Längsschnitt durch eine Membranbettkontur mit einer lateralen Ausdehnung von ca. 50 $\mu$m zeigt schematisch die Rauhigkeit der Silizium-Oberfläche nach den verschiedenen Präparationsschritten, wobei die vertikale Koordinate stark überhöht dargestellt ist.

Die durchgezogene Linie 10 zeigt schematisch eine typische Rauhigkeit der Silizium-Oberfläche unmittelbar nach der Laserablation. Die gestrichelte Linie 11 und die gepunktete Linie 12 zeigen schematisch die Oberfläche nach der Oxidation und dem HF-Ätzen. Da durch die Oxidation vornehmlich freistehende Konturelemente des Siliziummaterials betroffen sind, werden diese bei dem nachfolgenden Ätzschritt entfernt und es wird eine Reduzierung der Rauhigkeit erreicht, wodurch die Eignung der Kontur als Membranbett für eine Messmembran erhöht wird.

Die in Fig. 4 dargestellten Weißlichtinterferometerdaten stammen vom Zentrum der Oberflächen eines Membranbetts nach erfolgter Laserablation. Man erkennt, deutlich die gewünschte Form kreisförmig in Schichten abgetragen wurde. Die erzielte Rauhigkeit ist hier noch oberhalb der Größenordnung der Schichtdicke (250 nm), und ist noch mittels Oxidation und Ätzen zu bereinigen.

## Patentansprüche

1. Verfahren zum Herstellen eines Drucksensors, welcher eine Messmembran und mindestens ein Gegenlager aufweist, wobei die Messmembran gegenüber dem Membranbett des Gegenlagers positioniert und mit dem Gegenlagerkörper fest verbunden ist, wobei der Drucksensor weiterhin einen Wandler aufweist zum Wandeln einer druckabhängigen Verformung der Messmembran in ein elektrisches oder optisches Signal, wobei das Gegenlager einen Gegenlagerkörper mit einem Membranbett aufweist, welches eine Kontur zum Abstützen einer Messmembran (3) aufweist, wobei die Kontur im Wesentlichen der Biegelinie der Messmembran (3) entspricht, wobei das Verfahren die folgenden Schritte umfasst:

    Bereitstellen eines Gegenlagerkörpers, welcher Silizium aufweist;
    Abtragen des Siliziummaterials mittels Laserablation von einer Oberfläche des Gegenlagerkörpers;
    Oxidation der mit Laserablation bearbeiteten Oberfläche;
    Ätzen der bearbeiteten und oxidierten Oberfläche;
    Positionieren der Messmembran gegenüber dem Membranbett des Gegenlagers; und Verbinden der Messmembran mit dem Gegenlagerkörper.

**2.** Verfahren nach Anspruch 1, wobei das Abtragen mittels Laserablation schichtweise erfolgt.

**3.** Verfahren nach Anspruch 1 oder 2, wobei die Laserablation mittels ultrakurzer Laserpulse erfolgt, insbesondere mit Laserpulsen im Zeitbereich von einigen 100 Femtosekunden bis zu einigen 10 Pikosekunden.

**4.** Verfahren nach Anspruch 3, wobei die Dauer eines Laserpulses nicht mehr als 30 Pikosekunden, vorzugsweise nicht mehr als 20 Pikosekunden, weiter bevorzugt nicht mehr als 15 Pikosekunden, und besonders bevorzugt nicht mehr als 10 Pikosekunden beträgt.

**5.** Verfahren nach Anspruch 3 oder 4, wobei die Dauer eines Laserpulses beträgt beispielsweise nicht weniger als 100 Femtosekunden, insbesondere nicht weniger als 200 Femtosekunden

**6.** Verfahren nach Anspruch 3 oder 4, wobei die Leistung eines Laserpulses mehr als $10^{10}$ Watt / cm$^2$ beträgt.

**7.** Verfahren nach einem der vorhergehenden Ansprüche, wobei durch das Abtragen mittels Laserablation eine Kontur präpariert wird, welche rotationssymmetrisch um eine Achse senkrecht zur Oberfläche des Gegenlagerkörpers verläuft.

**8.** Verfahren nach Anspruch 7, wobei die Kontur beschrieben ist durch die Gleichung

$$D(r) = D_{max} (1 - (r / R)^2)^2,$$

wobei r der radiale Abstand des betrachten Punkts von der Achse ist, und D(r) die Tiefe gegenüber einer durch den Rand der Kontur bei r = R definierten Ebene beschreibt.

**9.** Verfahren nach Anspruch 1 bis 8, wobei die Kontur eine maximale Tiefe $D_{max}$ mit einem Wert von nicht weniger als 4 $\mu$m, insbesondere nicht weniger als 8 $\mu$m, bevorzugt nicht weniger als 12 $\mu$m und besonders bevorzugt nicht weniger als 16 $\mu$m aufweist.

**Claims**

**1.** Procedure designed to manufacture a pressure sensor, which has a measuring membrane and at least one counter-bearing, wherein the measuring membrane is positioned opposite the membrane bed of the counter-bearing and is connected in a fixed manner to the counter-bearing body, wherein the pressure sensor further comprises a converter to convert a pressure-dependent deformation of the measuring membrane to an electrical or optical signal, wherein the counter-bearing has a counter-bearing body with a membrane bed which has a contour to support a measuring membrane (3), wherein the contour essentially corresponds to the bending line of the measuring membrane (3), wherein the procedure comprises the following steps:

- Provision of a counter-bearing body, which features silicon;
- Removal of the silicon material from one surface of the counter-bearing body using laser ablation;
- Oxidation of the surface treated with laser ablation;
- Etching of treated and oxidized surface;
- Positioning of the measuring membrane opposite the membrane bed of the counter-bearing; and
- Connection of the measuring membrane with the counter-bearing body.

**2.** Procedure as claimed in Claim 1, wherein the removal process via laser ablation is layer by layer.

**3.** Procedure as claimed in Claim 1 or 2, wherein the laser ablation takes place using ultra-short laser pulses, particularly with laser pulses in the time range from several 100 femtoseconds to several tens of picoseconds.

**4.** Procedure as claimed in Claim 3, wherein the duration of a laser pulse is not more than 30 picoseconds, preferably not more than 20 picoseconds, more preferably not more than 15 picoseconds and particularly preferably not more than 10 picoseconds.

**5.** Procedure as claimed in Claim 3 or 4, wherein the duration of a laser pulse is, for example, not less than 100 femtoseconds, particularly not less than 200 femtoseconds.

**6.** Procedure as claimed in Claim 3 or 4, wherein the power of a laser pulse is greater than $10^{10}$ watts /cm$^2$.

**7.** Procedure as claimed in one of the previous claims, wherein, as a result of the removal by laser ablation, a contour is prepared which has rotational symmetry in relation to an axis that is perpendicular to the surface of the counter-bearing body.

**8.** Procedure as claimed in Claim 7, wherein the contour is described by the equation

$$D(r) = D_{max} (1 - (r / R)^2)^2,$$

where r is the radial distance of the observed point of the axis,
and where D(r) describes the depth in relation to a plane defined by r = R passing through the edge of the contour.

9. Procedure as claimed in Claim 1 to 8, wherein the contour has a maximum depth $D_{max}$ with a value of not less than 4 $\mu$m, particularly not less than 8 $\mu$m, preferably not less than 12 $\mu$m and particularly preferably not less than 16 $\mu$m.

**Revendications**

1. Procédé destiné à la fabrication d'un capteur de pression, lequel capteur comporte une membrane de mesure et au moins une butée, la membrane de mesure étant positionnée en face du lit de membrane de la butée et étant reliée de façon fixe avec le corps de butée,
pour lequel le capteur de pression comprend en outre un convertisseur destiné à convertir une déformation fonction de la pression de la membrane de mesure en un signal électrique ou optique, la butée comportant un corps de butée avec un lit de membrane, qui présente un contour destiné à supporter une membrane de mesure (3), le contour correspondant pour l'essentiel à la ligne de pliage de la membrane de mesure (3), lequel procédé comprend les étapes suivantes :

   - Mise à disposition d'un corps de butée, qui présente du silicium ;
   - Enlèvement de la matière de silicium au moyen d'une ablation laser de la surface du corps de butée ;
   - Oxydation de la surface traitée au moyen de l'ablation laser ;
   - Décapage de la surface traitée et oxydée ;
   - Positionnement de la membrane de mesure par rapport au lit de membrane de la butée ; et
   - Liaison de la membrane de mesure avec le corps de butée.

2. Procédé selon la revendication 1, pour lequel l'enlèvement s'effectue progressivement au moyen d'une ablation laser.

3. Procédé selon la revendication 1 ou 2, pour lequel l'ablation laser est réalisée au moyen d'impulsions laser ultracourtes, notamment au moyen d'impulsions laser de l'ordre de quelques centaines de femtosecondes à quelques dizaines de picosecondes.

4. Procédé selon la revendication 3, pour lequel la durée d'une impulsion laser n'est pas supérieure à 30 picosecondes, de préférence pas supérieure à 20 picosecondes, encore de préférence pas supérieure à 15 picosecondes et particulièrement de préférence pas supérieure à 10 picosecondes.

5. Procédé selon la revendication 3 ou 4, pour lequel la durée d'une impulsion laser, par exemple, n'est pas inférieure à 100 femtosecondes, de préférence pas inférieure à 200 femtosecondes.

6. Procédé selon la revendication 3 ou 4, pour lequel la puissance d'une impulsion laser est supérieure à $10^{10}$ watts /cm$^2$.

7. Procédé selon l'une des revendications précédentes, pour lequel est préparé, grâce à l'enlèvement de matière au moyen de l'ablation laser, un contour qui est en symétrie de révolution par rapport à un axe perpendiculaire à la surface du corps de butée.

8. Procédé selon la revendication 7, pour lequel le contour est décrit par l'équation

$$D(r) = D_{max} (1 - (r / R)^2)^2,$$

où r est la distance radiale du point considéré de l'axe,
et où D(r) décrit la profondeur par rapport à un plan défini pour r = R passant par le bord du contour.

9. Procédé selon la revendication 1 à 8, pour lequel le contour présente une profondeur maximale $D_{max}$ avec une valeur d'au moins 4 $\mu$m, notamment d'au moins 8 $\mu$m, de préférence d'au moins 12 $\mu$m et particulièrement de préférence d'au moins 16 $\mu$m.

Fig. 1

Fig. 2a

Fig. 2b

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7360431 B2

- US 20040256585 A1

**In der Beschreibung aufgeführte Nicht-Patentliteratur**

- **A. GILLNER, A. et al.** High quality laser machining for tool and part manufacturing using innovative machining systems and laser beam sources. *Proc. of the 3rd CIRP Int. Conf. High Performance Cutting (HPC),* 12. Juni 2008

- **POLSTER et al.** *MicroMechanics Europe Workshop Im,* September 2008